# EUROPEAN PATENT APPLICATION

(11) **EP 2 571 064 A1**
(43) Date of publication of application: **20.03.2013**
(21) Application number: 11405340.8
(22) Date of filing: 21.10.2011
(51) Int. Cl.: H01L 31/058, H01L 31/052, F03G 6/06

(54) **Hybrid solar concentrator comprising concentrating means, a photovoltaic device and a thermal device for producing electricity**

(30) Priority: 13.09.2011 IT MI20111643
(71) Applicant: Multi.Bay SA, 6814 Cadempino (CH); Franco, Baldi, 20148 Milano (IT)
(72) Inventor: Baldi, Franco, 20148 Milano (IT)

(57) **Abstract**

A hybrid solar concentrator for electric power generation comprising one (6) or more concentrating lenses (56.57) with different forms (1.3,4,5,40,45,47,48,49,55) placed at various distances between themselves (46,49,52) with different focal lengths and converging the energy of photons onto a central device (11) (liquid, oily or gaseous) (12,41), comprising a heater of a fluid (liquid, oily or gaseous) (10,12) placed in a sealed central circuit and under pressure (9,58), which expands as a result of the heat obtained from the concentrating lenses, flowing into fluid conduit (13) pushing a rotor with unidirectional motion (30) comprising a rotating magnetic or spring pin (31,32) rotating in one direction and held in place (closed-circuit and under pressure), through more positioning balls (16). Said heated fluid flowing through unidirectional valves (28,29,34,35) towards a special sealed container (38) at solid state, liquid or gas, acting as cooler with filling valves (39,53). The cooled fluid shrinks and re-enters, through unidirectional valves (34,35), the central container (9), closing the fluid circuit and being heated up again to repeat the cycle of thrust of the rotor blades (30). The rotor is connected through the magnetic attraction of polarized magnets (22) to an underlying dynamo, rotating and generating electricity. The system further includes photovoltaic cells sensitive to both to the visible and invisible light (infrared, etc..) and to the heat (7) put under the main lens (6). The device uses both visible and invisible light (infrared, ultraviolet and gamma rays, X,etc..) with various concentration points (40,42.43,45,50).
The advantage of the invention is a compact concentrator generating more energy at lower cost.

## Description

The present invention relates to a multi-functional generator, "hybrid" and compact of **electric energy,** obtained by the "concentration" of solar energy photons, with various types of focalizatons (both of visible and invisible light) in the specific points of an innovative device, with "improved characteristics" if compared with other systems, both for its extremely compacted dimensions and for its major electric power "watts", at the lower cost, if compared to the existing photovoltaic and parabolic concentration panels. It's include a **"lenticular concentrator,"** with pre-emption already claimed and released for "microwave" in the patents of Mr. Baldi Franco; for an anti-collision radar system with pre-emption, Italian patent IT22292A/89 of 7 November, 1989. and European of 2 November 1990. EPO 0427131 (A2) and 18.11,1996 IT 1.29 7.826 and of 28.10,1997 IT 1.29 7.992. with issue of European Patent EPO 843182 (A2) American U.S. 5,991,474 Chinese ZL. 97120178.1 with further patent improvements 97120178.1 IT RE 2006 A 001522 of 15 December 2006, European patent EP 1933163 (A1) American Patent:U.S.7.548.190 (B2) and Chinese Patent: CN101206261(A).

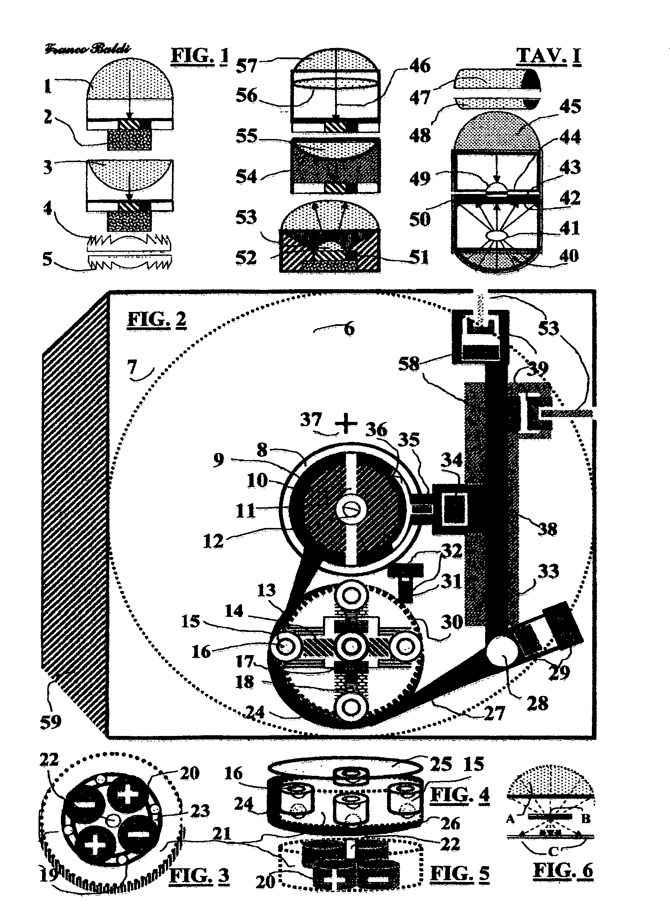

The "lenticular" system in the a.m. patents, is also further developed for the photons in the whole spectrum of visible and invisible light (infrared, ultraviolet, X-ray range, etc..) The photons are focused through one or more lenses with different focalizations on a device "target" producing electric energy both through the heat and through the conversion of the photons into energy. The invention is substantially composed by a block generator of electric current, produced with a device (usually liquid, plasma, or gas) located centrally to the fire concentrator of photons, with one or more lenses, allowing to generate electric energy, in the multiple effect produced by one or more of these devices, detectors, as a consequence of warming and of the photons conversion into electric energy, produced by an appropriate device, which in turn heats a liquid under pressure (oily, plasma or gas) for induction, in a closed circuit perfectly sealed and at set pressure, determining the molecular expansion of the same fluid, due to "joule" as a result of the increased temperature, flowing out to particular falling and folding flaps that in order to get the maximum rotation pushing of a toothed rotor and sealed, in a closed circuit under pressure and placed in a close contact; by polarized magnets, with a dynamo, producing electric energy for induction, as a result of the magnetic rotation of the rotor. The device provides several concentrator points of the photons through different angles with different focusing distances, either directly or by reflection "convergent or divergent "from the main focus of one or more lenses. The simultaneous action of heating and conversion of photons into electric energy, added to the dynamo effect, combine to produce a triple generation of electric energy, produced singularly and for the sum of the systems, increasing the total power watts, and if compared to photovoltaic cells with silicon, gallium arsenide, organic material or parabolic concentration,. the invention is smaller than 90%, This key feature is ameliorative, in order to obtain energy electric in a smaller space and with more power watts, enabling innovative solutions and competitive, even for vehicles, trains, satellites, aircraft, ships and for various uses both civilian and military. The invention is described below according to its typical configurations, supplied only for explanation and without limitation, with reference to the attached drawings as per table (I) The Figure one shows the block diagram, various forms of positioning with focalization, selective of one or more lenses, hemispherical, fresnel, semi-cylindrical, according to the kind of focalization required, placed at different distances from the focus of the maximum concentration, with an effect at points for hemispherical lens or straight points for semi-cylindrical or ovoid lenses, suitable for photovoltaic sensors in series on the same line. The possibility to assemble with multiple generators of electric energy, in series or parallel, allows to obtain the desired output volts and watts. Figure two, includes a focused lens (6) with the central device generator of electric energy (12) both for heat reaction and by revelation of thermal photons. It includes a toothed rotor (21,30) rotated by various folding flaps which produce a rotatory push as a consequence of the expansion of the fluid heated by the effect "joules" The rotor with the polarized magnets (20) is indirectly highly "Glued" by contact with polarized magnets to a dynamo. It includes a container (24) containing an expansible fluid by heat, and with unidirectional valves for the cooled fluid, produced by a cooler (38) solid or liquid or gas. The figure 3 and 4 represent a perspective view of the toothed rotor, in a closed circuit sealed, containing polarized magnets for the indirect connection, isolated with the dynamo Figure 6 represents in a schematic way, a divergent focalization, obtained by a single lens (a) distanced from its focus (B) over the central point of maximum focus (C) oriented in a sub-plain divergent the sunlight, both visible and invisible. With reference to the figures can be observed: In Figure 2, a concentric lens (6) that focuses sunlight on a "particular device" placed in the maximum central focus (12) with the dual function of transforming photons into electric energy, also through the heating of the device (11.37) with an output with a negative - or positive + polarity according to the functional capabilities of the device. An underlying cell (10) producing electric energy (of any type) receives the photons, through a diverging focalization point, from the point of maximum focus, included in a container (8) containing a thermo-conductive substance, heated per induction from the device (12) became extremely hot due to the concentric and heating lens through a sealed channel (9) a fluid under pressure (liquid, oily, or gas) that expanding itself, as a consequence of the "joule" effect, flows to the entry (13) feeding a toothed rotor (30) blocked by a unidirectional pin (31) with magnet (32) or spring allowing only one direction of rotation. The fluid at high temperature, through the corridor (24) and consequently to the different pressure, push several fins (15) falling or folding (18) in their magnetic place (17) or spring (14) hold in their place by spheres (16) for the output flowing (27) where through a unidirectional check valve (28,29) enters into the container (38) restricting its molecular volume as a result of the cooling induced by a cooler (33) containing gas or liquid, or solid-components. The cooled fluid is directed through a magnetic valve (34) or spring (35) to a unidirectional valve (36) and then again re inserted in the container (9) repeating the rotatory cycle, as a consequence of heating and cooling fluid. The release of the fluid and of cooling liquid or gas, is through the valves (39,53,58). The block containing the entire system (7) can also be covered under a microscope, by photovoltaic and painted cells or other systems, generating electric energy of the photons of sun and light by infrared solar etc.. as per directly or indirectly reflection. Figure 3, this represents saw-tooth rotor (21,30) at the bottom, with a groove (23) of balls positioning housing (19.22), there are also visible the polarized magnets (20) for the connection to a dynamo that generates electric energy for the rotation with a strong magnetic attraction of the rotor's polarized magnets. Figure 4 shows a section of the superior rotor (25) where within the passage (24) containing the heated fluid, we can see the cylindrical fins (fins or folding not drawn) incurred by the balls in their place(16). Figure 5 shows a central pin (22) for the positioning of the rotor to the external container (25) that encloses all the rotating closed-loop system. Figure 6 presents a lens (A) focusing the photons in the point (B) and further to the focal length, different from the central point of maximum focalization, the photons are divergent opening themselves in a way less concentrated in the point (C). This is to avoid that an excessive heat can destroy any component, at the base of the system. The principle of multiple focalizations, is shown with the lenses (40.45) placed in opposition between themselves, in order to receive the sunlight and the other light from the infrared, coming from the same or different direction. You can see the double concentrator effect with focal divergence (41) of maximum multi-directional concentration (44) composed by one or more lenses (49). The Figure 1, shows some formal variation and positioning of multiple lenses (1, 3,4,5) (57.56) placed at different distance from the main focus (54.55) for an attenuation of the concentrated energy power, produced by one or more lenses (51, 52.53 of different forms, both hemispherical and cylindrical (47.48), with a straight concentration of lenses focus of the lens, with one or more planar slopes, illuminating one or more suitable devices (of any kind), placed in series or parallel and capable of generating electric energy.

## Claims

1. **A Closed-Circuit Device characterized by an innovative generator of electric energy,** hybrid and compact with extremely reduced dimensions, with pre-emption already claimed and released for her "lenticular concentration" in the "microwaves" of the patent of the **Italian inventor Baldi Franco;** for a **anti-collision radar system with pre-emption,** Italian patent IT22292A/89 of the 07 November 1989. European Patent of 02 November 1990. EPO 0427131 (A2) and of 18,11,1996 IT 1,29 7,826 and of 28,10,1997 IT 1,29 7,992. with release of European patent EPO 843182(A2) American US 5,991,474 Chinese ZL 97120178,1 with further improvements in the patent IT Re 2006 A. 001522 of 15 December 2006, European patent EP 1933163 (A1) American US Patent 7,54 8,190 (B2) and Chinese Patent CN 101206261 (A.) that includes a central focalization of the photons of the visible and invisible light in direct or convergent way, divergent or of reflex, through one or more lenses focusing a semi-sphere, fresnel, semi-cylindrical or ovoid (1,3,4,5.40.45, ,47,48.56,57) put to different distances between themselves, with different position in the space (41,46) frontal, upon, under or lateral, from the focus produced by the focused photons. It includes "any device" placed to on the focus centre, at the solid, liquid or gaseous state, (12) **"able to convert"** the photons concentrated on itself (from one or more lenses), producing electric energy, through the double function, both of the **photovoltaic detection,** that through the **heating** of the central component (10) placed under the heater (12) with production (11,37) of electric energy with a positive or negative polarity according to the system requirements.

2. **Characterized as per claim 1. that the device** (11,12) heated by the focused photons (of one or more lenses), heats for induction any substance (9) thermo-conductor, (transparent or less) containing an **under pressure fluid,** liquid or gaseous **thermo expandable** (10), contained into a container (8) toward channel (10) with inlet valves of the cold fluid, magnet working by magnet or by spring (35,36) All closed and sealed with fixed pressure, (9,12,24)

3. **Claim characterized by the fact of an unidirectional** rotor (30) immersed in the expandable fluid with closed circuit, it is located in its place by the cylinder (22,) it includes serrated teeth with appropriate form, allowing only unidirectional rotation, starting from the block or a pin (31) with magnetic or spring loading (32) Claim **characterized by** cylindrical flaps (15) with supporting spheres (16) or with other form, (rigid or flexible fan), them reenter and alternatively go out the rotor, as a result of magnets (17) or springs (14) set on spheres of positioning (16) in her own river bed (22) receiving the heated fluid to pressure, through the entrance (13) it crosses the corridor (24) for "effect Joule" of molecular expansion, consequent to the heat of the device (11,12) The alternating potential "warm - cold", through unidirectional valves (35,36,28,29) it produces a different pressure, inducing the fins of the rotor to an unidirectional rotator motion, for then to flow out to the exit (27) with opportune selective valves (28,29) to a circuit cooler

4. **Claim characterized, by cylindrical fins** (15) with spheres of support (16) or of other form, (to rigid or flexible fan), they reenter and they alternatively go out of the rotor, because of magnets (17) or springs (14) set on positioning spheres (16) in its channel (22) receiving the heated fluid under pressure, through the entry (13) that pass through the channel (24) as a result of "Joule" effect with molecular expansion, as a consequence of the device heating (11,12) The alternating potential "hot - cold", through unidirectional valves (35,36,28,29) produces a different pressure, inducing the rotor flaps to an unidirectional rotatory motion, in order to flow out by the exit (27) with appropriate selective valves (28,29) to a cooler circuit

5. **Claim characterized by a sealed container** (33) to the solid state, liquid or with cooling gas. The system with filling valves (39,53, 58) repeats its own functional cycle by impulses further to the rhythmic unidirectional expansion of the fluid, cooling the heated fluid coming from the rotor. The lower pressure of the cooled fluid (35) as a result of the molecular narrowing, induced by the thermal shock of the cooler (38), it allows the working of an innovative closed-circuit generator of electric energy, with extremely compacted dimensions and miniaturized to the inside and not to the outside, as others thermic reaction systems.

6. **Claim characterized by the innovative fact, that The rotor** is very close to polarized magnets (20) that provides, by contact "pasting" (as a result of the strong magnetic attraction) to rotate a dynamo, generating electric energy, "pasted" to it from the strong magnetic attraction, but isolated, from the circuit in order to avoid dispersions of the fluid under pressure.

7. **Claim characterized by several innovative features,** of electric energy generation, through one or more cell sensors (9) set in various positions, and able to transform into electric energy the whole spectrum of the visible and invisible light and the thermic radiation, (infrared) direct or indirect or divergent, produced by the focus concentrator of one or more lenses, with output of electric energy (37) with positive (+) or negative (-) polarity, originated by one or more PV photovoltaic cells of any type, placed on various plans (7,42,43,50,51,52,53) in different positions of the system, placed above , under, or lateral (42,43,44,50,) with one or more lenses (49,53,56,57) at different distance (46,53) of focusing (40,41,) or positioning (41,49,) straight (1,6,45,47,49,52,57,) or inverted (3,48) or of different forms (4,5) not limitative, frontally set under (or above or lateral) the component (2,12,41) with different focalizations. Including hemispherical lenses, semi-cylindrical or ovoid (47,48) more or less elongated, and set at adjustable distance (46) from the central focus, of the focalization, in "rectilinear" way and not only "Punctiform" of the hemispherical focalization or fresnel etc.

8. **Claim characterized by one or more electric energy generators** placed in series or parallel, to increase the produced power volt - watt. Through photovoltaic and thermal sensors (of any type), able to produce electric energy, both through the heat by conversion of the photons of the visible and invisible light, alone and also in both ways. through coaxial sensory components, adjacent and placed in series and/or in parallel (41,49,52,) under or above the maximum focalization, also in divergent way or of reflex FIG. 6 (A,B,C,) as per claims (1,7) set with same disposition, for one or more lenses with variable divergent focalization, convergent or by reflex.

9. **Claim characterized by the fact that the system results hybrid and multivalent,** as it assembles in a reduced space, more electric energy generation sources, with possibility to produce more generators of various models and functions, exploiting a single or more claims of the whole brevet assembled in an only multifunctional generator, in order to reach the maximum power watt, but with extremely reduced and compacted dimensions. Comprising one or more outputs with different voltage and energy power watt positive or negative, in continued or alternated current.

10. **Claim characterized by the fusion of more innovative characteristic,** able to build a range of different generators of electric energy with reduced dimensions of 90% for civil and military uses, for vehicles of any kind travelling on rubber and rails, for spatial use, sea or earthling, for satellites, airplanes, ships, etc. that need renewable and not polluting electric energy generation at low cost, and with minimum encumbrance dimension.
